# DEMANDE DE BREVET EUROPEEN

(11) **EP 2 878 701 A1**
(43) Date de publication de la demande: **03.06.2015**
(21) Numéro de dépôt: 14195213.5
(22) Date de dépôt: 27.11.2014
(51) Int. Cl.: C23C 18/16, C23C 18/36, C23C 18/40, C23C 18/44, C23C 18/18

(54) **Procédé amelioré de métallisation d'un materiau poreux**

(30) Priorité: 29.11.2013 FR 1361849
(71) Demandeur: Commissariat à l'Énergie Atomique et aux Énergies Alternatives, 75015 Paris (FR); STmicroelectronics SA, 92120 Montrouge (FR)
(72) Inventeur: Halimaoui, Aomar, 38660 La Terasse (FR); Vandroux, Laurent, 38570 Le Cheylas (FR)
(74) Mandataire: Brevalex

(57) **Abrégé**

Procédé de métallisation d'un matériau poreux comprenant le dépôt de matériau métallique en phase liquide, à l'aide d'une solution comprenant des ions métallique, les conditions de température de dépôt, de pH de la solution, et de concentration en ions métallique de la solution étant choisies de manière à permettre une vitesse de dépôt inférieure ou égale à 0.1 nm/min.

## Description

### DOMAINE TECHNIQUE ET ART ANTERIEUR

La présente description concerne le domaine des structures poreuses métallisées, et en particulier celles à base d'un matériau semi-conducteur poreux que l'on a rempli de matériau métallique.

Elle prévoit un procédé de réalisation d'une structure poreuse métallisée avec un meilleur remplissage et une répartition plus uniforme du matériau métallique dans l'épaisseur de la structure.

Il est connu de réaliser une métallisation de matériau poreux, par une technique de dépôt électrolytique ou d'électrodéposition qui nécessite un apport de courant électrique ou bien par une méthode de dépôt de type communément appelé « électroless » basée sur une réaction auto-catalytique.

Le document « Electrodeposition of metals into porous silicon » de Jeske et al., Thin Solid films, 1995 présente différentes techniques de métallisation de Si poreux à l'aide d'Au, de Cu ou de Ni.

La figure 8 de ce document montre qu'il est difficile d'obtenir une répartition uniforme de métal sur toute l'épaisseur du silicium poreux, le métal ayant tendance à se concentrer principalement à la surface de la couche de Si poreux.

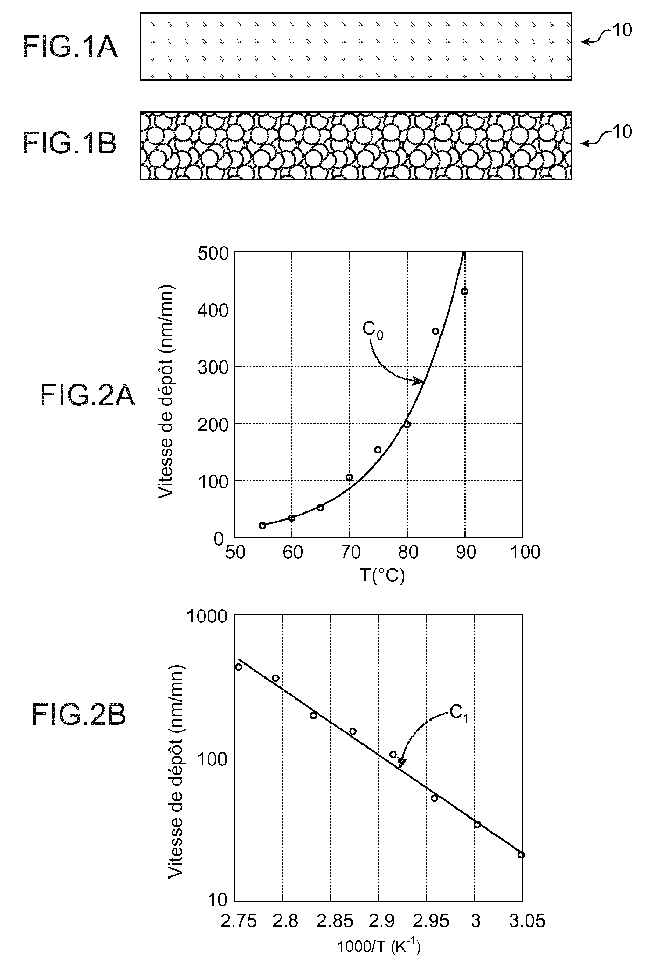

Cette difficulté ressort également du document « Différent Behaviour in immersion Plating of Nickel on Porous Silicon from Acidic and Alkaline Fluoride Media », de Harraz et al., Journal of the Electrochemical Society, 2003, comme cela est illustré sur les figures 1 et 2. Une vue en coupe de Si poreux que l'on a essayé de remplir par de l'or ou du nickel, montre en effet une répartition du métal essentiellement en surface de la couche de Si.

Il se pose le problème de trouver un nouveau procédé de métallisation d'un matériau poreux, qui permette au métal de pénétrer sur toute l'épaisseur du matériau poreux et conduise à une meilleure répartition du métal dans l'épaisseur du matériau poreux.

### EXPOSÉ DE L'INVENTION

La présente invention concerne tout d'abord un procédé de métallisation d'un matériau poreux par dépôt de matériau métallique en phase liquide à l'aide d'une solution comprenant des ions métallique.

Selon l'invention, une vitesse de dépôt de matériau métallique faible est prévue.

Les conditions de température de dépôt, de pH de ladite solution, et de concentration en ions métallique de la solution dans laquelle le matériau poreux est trempé, sont choisies conjointement de manière à permettre une vitesse de dépôt du matériau métallique inférieure ou de l'ordre de 0.1 nm/min.

Une vitesse de dépôt inférieure ou égale à 0.1 nm/min permet d'améliorer le remplissage du matériau poreux, et en particulier d'obtenir un remplissage total de la couche poreuse ou du substrat poreux.

Une telle vitesse de dépôt permet également d'obtenir un remplissage uniforme en matériau métallique dans l'épaisseur du matériau poreux.

La mise en oeuvre d'un dépôt en phase liquide présente notamment pour avantage d'être beaucoup moins couteuse que celle faisant appel aux procédés de dépôt en phase gazeuse.

Le matériau poreux que l'on métallise peut être sous forme d'un substrat ou d'une couche dont l'épaisseur peut atteindre plusieurs centaines de µm.

Le matériau poreux que l'on métallise peut être un matériau à porosité ouverte.

Le matériau poreux que l'on métallise peut être un matériau semi-conducteur ou un matériau minéral micro-poreux de type zéolithe

Le matériau poreux que l'on métallise peut être avantageusement du Si.

La concentration en ions métallique est de préférence choisie inférieure ou égale à une concentration seuil prédéterminée.

Pour atteindre une vitesse de dépôt de matériau métallique inférieure à 0.1 nm/min, la concentration molaire de la solution contenant les ions métalliques est de préférence prévue inférieure à 0.1 M.

La température est de préférence choisie inférieure ou égale à une température seuil prédéterminée.

Pour atteindre une vitesse de dépôt de matériau métallique inférieure à 0.1 nm/min, la température du bain chimique utilisé et contenant la solution de dépôt peut être choisie dans l'intervalle ]0°C ; 25°C] et de préférence proche de 0°C.

Le pH de la solution de dépôt est également de préférence un pH acide ou faible.

Le pH de la solution est ajusté en fonction de celui de la température et de la concentration en ions métalliques, tout en empêchant une dissolution du matériau poreux.

Pour atteindre une vitesse de dépôt de matériau métallique inférieure à 0.1 nm/min, le pH de la solution de dépôt peut être choisi inférieur à 7 et de préférence inférieur ou égal à 6, avantageusement inférieur ou égal à 4.

La solution de dépôt peut être alors une solution contenant des ions Ni+ ou Cu²⁺ ou Au³⁺ ou Ag⁺ afin de métalliser le Si poreux.

Pour améliorer le remplissage, la solution de dépôt peut comprendre un agent surfactant.

En variante, on peut placer le matériau à métalliser dans une solution contenant un agent surfactant préalablement au dépôt de matériau métallique.

La présente invention s'applique à la métallisation de structures poreuses dont la porosité est constituée de pores voire de fissures ou de tranchées.

L'invention concerne également un procédé de fabrication d'un dispositif microélectronique comprenant un procédé de métallisation selon l'une quelconque des revendications précédentes.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
- les figures 1A-1B illustrent une porosification d'un substrat semi-conducteur,
- les figures 2A-2B illustrent des courbes de vitesse de dépôt en phase liquide de Ni en fonction de la température de dépôt pour un pH donné de 6 de la solution de dépôt contenant des ions Ni+; et une concentration molaire donnée de 0.2 M en ions Ni+ de la solution de dépôt,
- la figure 3 illustre une courbe de vitesse de dépôt en phase liquide de Ni en fonction du pH de la solution de dépôt utilisée contenant des ions Ni+,
- les figures 4A-4B illustrent des courbes de vitesse de dépôt en phase liquide de Ni en fonction de la température de dépôt pour un pH donné de 4 de la solution de dépôt contenant des ions Ni+; et une concentration molaire donnée de 0.2 M en ions Ni+ de la solution de dépôt,
- la figure 5 illustre une courbe de vitesse de dépôt en phase liquide de Ni sur en fonction de la concentration molaire en ions Ni+ de la solution de dépôt utilisée,
- la figure 6 illustre une courbe de vitesse de dépôt en phase liquide de Ni pour un pH donné de 4 de la solution de dépôt utilisée et contenant des ions Ni+, et une concentration molaire en ions Ni+ inférieure à une concentration seuil de 0.1 M,
- les figures 7A-7B illustrent des courbes de concentration en Ni dans l'épaisseur d'une couche de Si poreux, respectivement pour une vitesse de dépôt prévue telle que suivant l'invention inférieure à 0.1 nm/min, et pour une vitesse de dépôt de 7 nm/min,
- les figures 8A-8C illustrent différents types de structures poreuses constituées de porosités de fissures et auxquelles un procédé de métallisation suivant l'invention est susceptible d'être appliqué.

Comme cela est usuel dans la représentation des structures semiconductrices, les diverses vues en coupe ne sont pas tracées à l'échelle. Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

Un exemple de procédé, suivant l'invention, de métallisation d'une structure poreuse, va à présent être décrit.

Le matériau de départ de ce procédé peut être un substrat 10 massif à base de matériau semi-conducteur (figure 1A), tel que par exemple du Si, que l'on rend poreux (figure 1B), par exemple par le biais d'un procédé de gravure électrochimique en milieu acide fluorhydrique (HF).

Le substrat 10 peut être dopé selon un dopage de type P, avec un niveau de dopage qui peut être compris entre 10¹⁵ cm⁻³ et 10¹⁹cm⁻³. Dans cet exemple, le niveau de dopage peut être par exemple de l'ordre de 10¹⁹cm⁻³. Pour un tel niveau de dopage, la porosité de la couche de silicium poreux peut être comprise entre 20% et 85% et ajustée en fonction des conditions électrochimiques. La porosité du substrat 10 peut être par exemple de l'ordre de 80% et son épaisseur par exemple de l'ordre de 1 µm.

Le diamètre encore appelé dimension critique des pores est compris(e) entre plusieurs nanomètres et plusieurs dizaines de nanomètres. Dans cet exemple, le diamètre des pores peut être supérieur à 5 nm, par exemple de l'ordre de 10 nm. Le procédé suivant l'invention s'applique tout particulièrement au remplissage de pores de faible taille, i.e. ayant une dimension critique ou un diamètre inférieur à 20 nm.

Une activation de la surface de matériau poreux peut être mise en oeuvre préalablement à une métallisation du substrat 10 poreux.

Pour cela, un premier trempage dans une solution à base de SnCl₂, par exemple de concentration molaire de l'ordre de 0.3M, pendant une durée par exemple de l'ordre de 2 minutes, peut être réalisé.

Ensuite, un rinçage et un deuxième trempage dans une solution qui peut être à base de PdCl₂, et par exemple de concentration molaire de l'ordre de 2*10⁻³M, pendant une durée par exemple de l'ordre de 1 minute peut être effectué.

Ces étapes de trempage permettent de modifier et d'activer la surface du matériau poreux.

Le matériau poreux peut être également soumis, préalablement à l'étape de métallisation, à un agent surfactant prévu pour diminuer la tension superficielle du matériau poreux et augmenter ainsi sa mouillabilité. L'agent surfactant peut être dispensé sur le substrat 10 par le biais d'une buse ou peut être sous forme d'un bain dans lequel le substrat 10 est immergé. L'agent surfactant peut être par exemple de l'éthanol. D'autres agents surfactants tels que par exemple du méthanol, de l'acide acétique, du stéarate de sodium, du benzène sulfonate, ou un solvant organique peuvent être également utilisés.

Avantageusement, l'agent surfactant peut être intégré dans la solution de dépôt permettant de métalliser le matériau poreux.

Après immersion dans le surfactant, un rinçage du substrat 10, sans séchage peut être ensuite réalisé.

On effectue ensuite le dépôt de matériau métallique en phase liquide, le matériau métallique de remplissage se trouvant sous forme d'ions métalliques présents dans une solution liquide de dépôt.

Cette solution de dépôt peut comprendre par exemple une solution à base de NiSO₄, contenant des ions métalliques Ni+ lorsqu'on souhaite métalliser le substrat poreux par du Nickel.

D'autres métaux tels que l'Or (Au), le cuivre (Cu), l'argent (Ag) peuvent être déposés en remplaçant le sel de Ni (NiSO₄) par un sel du métal à déposer. Pour effectuer une métallisation avec de l'Au on peut par exemple utiliser une solution d'Aucl₃. Pour réaliser une métallisation avec du Cu on peut par exemple utiliser une solution de CuSO₄, tandis que pour réaliser une métallisation avec de l'Ag on peut par exemple utiliser une solution d'Ag₂SO₄.

La concentration molaire en ions Ni+ de cette solution est de préférence inférieure à 0.1M et peut être par exemple de l'ordre de 0.05 M. Un agent réducteur tel que par exemple de l'hypophosphite de sodium Na₂H₂PO₂ selon une concentration molaire par exemple de l'ordre de 0.1 M peut être également intégré à la solution de dépôt, tout comme un agent complexant tel que par exemple de l'acide lactique CH₃CHOHCO₂ selon une concentration molaire de 0.2 M.

Pour adapter le pH de la solution de dépôt et en particulier rendre acide cette solution, un acide tel que par exemple de l'acide sulfurique H₂SO₄ dilué peut y être intégré.

Ensuite, on peut effectuer des étapes de rinçage et de séchage.

Les inventeurs ont découverts que pour permettre un remplissage du substrat poreux uniforme et de préférence sur toute son épaisseur, on prévoit, selon l'invention, de mettre en oeuvre le dépôt de matériau métallique selon une vitesse de dépôt très faible, et en particulier dans une gamme de vitesse de dépôt inférieure ou égale à 0.1 nm/min.

Une telle gamme de vitesse de dépôt n'est pas aisée à obtenir, en particulier en phase liquide.

Les inventeurs ont découverts que pour atteindre une telle gamme de vitesse de dépôt inférieure ou égale à 0.1 nm/min, une adaptation conjointe des conditions de pH, de température de la solution, et de concentration de la solution en ions métalliques est requise.

La température de la solution de dépôt fait partie des paramètres à adapter pour atteindre une faible vitesse de dépôt, une température de dépôt prévue basse, i.e. au moins inférieure à 25°C et proche de 0°C étant favorable à une vitesse de dépôt faible.

Les figures 2A et 2B donnent des exemples de courbes d'évolution C₀, et C₁ de vitesse de dépôt en fonction de la température obtenues pour un exemple de solution de dépôt ayant une concentration molaire en NiSO₄ de l'ordre de 0.2 M, une concentration molaire en hypophosphite de sodium de l'ordre de 0.3 M, une concentration molaire en acide lactique de l'ordre de 0.25 M, avec un pH de l'ordre de 6.

Ces courbes C₀ et C₁ montrent une diminution de la vitesse de dépôt avec la température.

Pour atteindre une vitesse de dépôt inférieure à 0.1 nm/min, un ajustement concomitant d'autres paramètres que la température est ainsi requis.

Le pH fait également partie des paramètres à adapter pour atteindre une faible vitesse de dépôt. Un pH faible est favorable à une vitesse de dépôt faible.

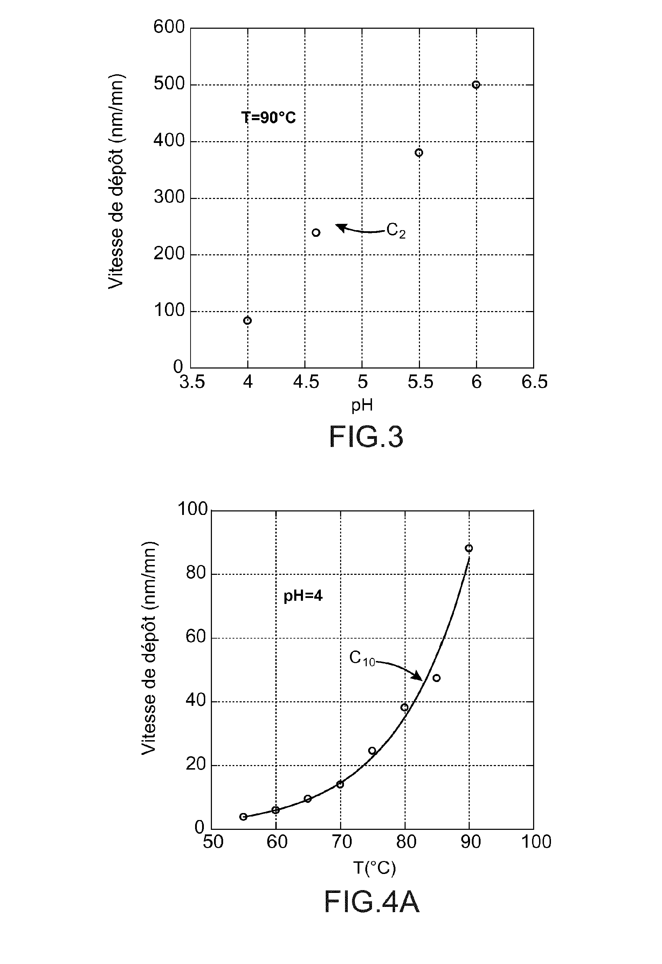

La figure 3 donne un exemple de courbe d'évolution C₂ de vitesse de dépôt en fonction du pH de la solution de dépôt pour un exemple de solution de dépôt ayant une concentration molaire en NiSO₄ de l'ordre de 0.2 M, une concentration molaire en hypophosphite de sodium de l'ordre de 0.3 M, une concentration molaire en acide lactique de l'ordre de 0.25 M, à une température de l'ordre de 90°C. Cette courbe C₂ montre une diminution de la vitesse de dépôt avec le pH.

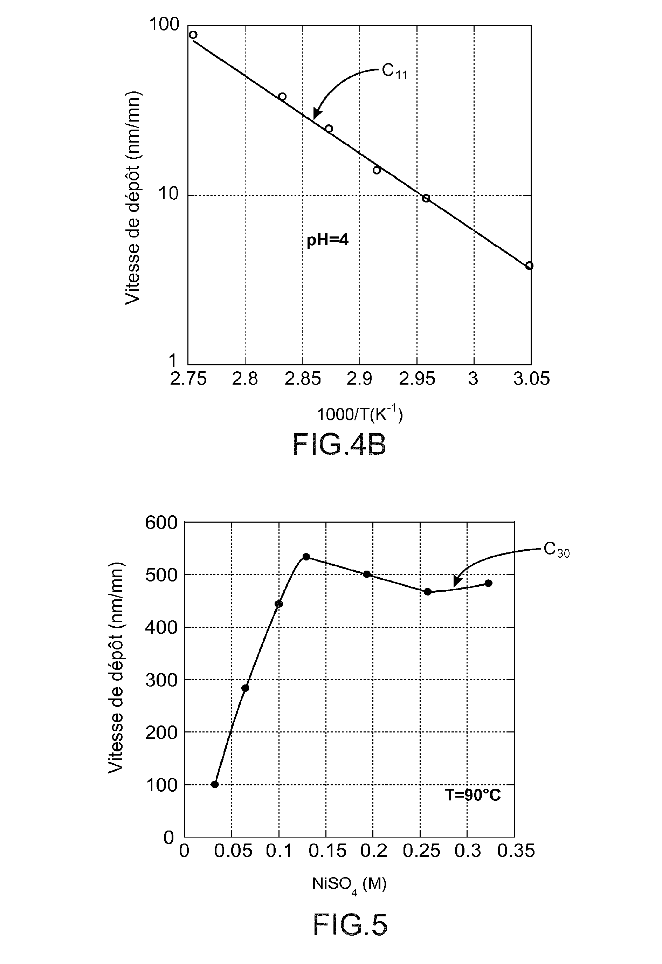

Les figures 4A et 4B donnent des exemples de courbes d'évolution C₁₀, et C₁₁ de vitesse de dépôt en fonction de la température obtenues pour l'exemple de solution de dépôt donné précédemment ayant une concentration molaire en NiSO₄ de l'ordre de 0.2 M, une concentration molaire en hypophosphite de sodium de l'ordre de 0.3 M, une concentration molaire en acide lactique de l'ordre de 0.25 M et un pH de l'ordre de 4, inférieur à celui de l'exemple des figures 2A-2B. Ces courbes C₁₀, C₁₁ montrent une vitesse de dépôt qui diminue avec la température et qui reste inférieure à la vitesse de dépôt de l'exemple des figures 2A-2B. Une extrapolation de ces courbes montre que l'on peut atteindre à une température de 25°C et un pH=4, une vitesse de dépôt de l'ordre de 0.15 nm/min.

Pour atteindre une vitesse de dépôt inférieure à 0.1 nm/min, en plus d'adapter la température et le pH, un ajustement concomitant de la concentration en ions métalliques est effectué. Dans cet exemple, le pH est de préférence choisi inférieur à 7, et de préférence inférieur à 6, de manière à obtenir une vitesse de dépôt faible tout en empêchant une dissolution du Si poreux.

La figure 5 donne une courbe d'évolution C₃₀ de la vitesse de dépôt en fonction de la concentration en ions métalliques Ni+ pour un exemple de solution métallique de dépôt à base de NiSO₄ ayant un pH de 4, à une température de l'ordre de 90°C.

Cette courbe C₃₀ montre que la vitesse de dépôt reste constante au deçà d'une concentration seuil, qui, dans cet exemple, est de l'ordre de 0.1 M.

En dessous de cette concentration seuil, on note une diminution importante de la vitesse de dépôt.

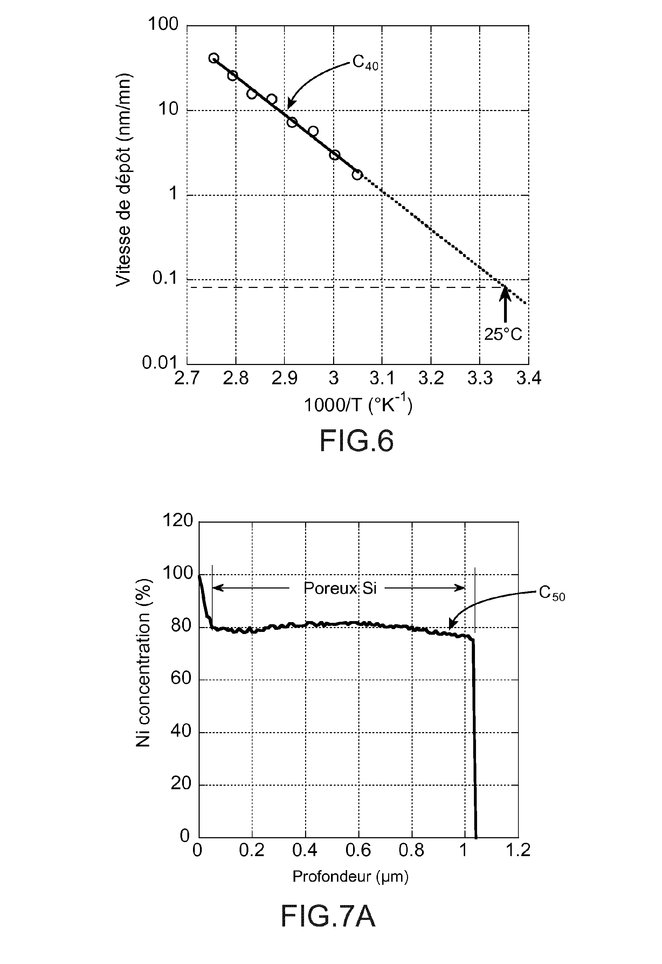

La figure 6 donne une courbe d'évolution C₄₀ de la vitesse de dépôt en fonction de la température pour un exemple de solution de dépôt à base de NiSO₄ ayant un pH acide égal à 4, une concentration de la solution métallique NiSO₄ de l'ordre de 0.05 M choisie ainsi en dessous de la valeur de concentration seuil, une concentration molaire en hypophosphite de sodium de l'ordre de 0.1 M, une concentration molaire en acide lactique de l'ordre de 0.2 M, et un pH égal à 4 ajusté par une dilution de H₂SO₄.

Avec de telles conditions de pH de concentrations en ions métalliques de la solution de dépôt, et de température, on obtient une vitesse de dépôt de l'ordre de 0.08 nm/min qui est donc inférieure à 0.1 nm/min.

La figure 7A donne un exemple de courbe C₅₀ obtenue par spectroscopie de rétrodiffusion de Rutherford (« Rutherford Backscattering Spectroscopy », ou RBS) de profil de concentration en Ni dans une couche de Si poreux métallisée à l'aide d'un procédé suivant l'invention, en fonction de la profondeur dans la couche de Si poreux.

Cette couche métallisée est du type du substrat 10 décrit précédemment, dopée type P+, d'épaisseur de 1 µm, avec une porosité de l'ordre de 80 % et des pores de diamètre de l'ordre de 10 nm. Le dépôt de matériau métallique a été réalisé dans des conditions de température de dépôt de 25°C, de pH égal à 4, de concentration molaire en ions métalliques de la solution métallique NiSO₄ adaptées pour obtenir une vitesse de dépôt inférieure à 0.1 nm/min. Le profil a été mesuré après un séjour de la couche de Si d'une durée de l'ordre de 2 heures dans la solution de dépôt.

Pour cette durée de 2h, on obtient un remplissage total des pores. Une durée de séjour plus courte, (i.e. inférieure à 2h) permet d'obtenir un tapissage de la surface des pores par le métal.

La courbe C₅₀ montre un remplissage de la couche de Si par le Ni sur toute son épaisseur et une concentration en Ni uniforme sur toute l'épaisseur de la couche de Si métallisée.

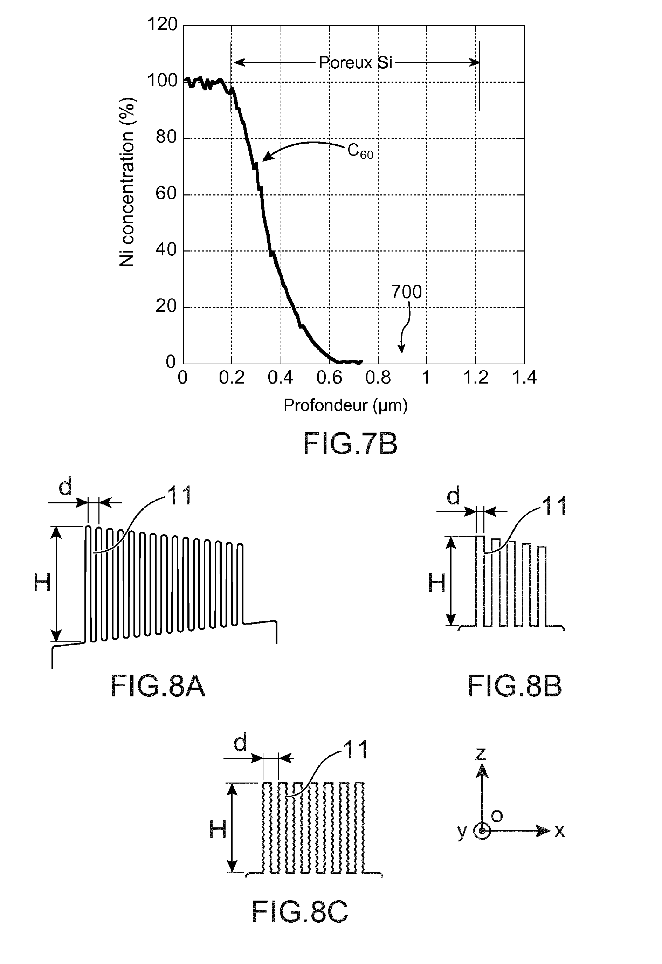

A titre de comparaison, une courbe C₆₀ de la figure 7B également obtenue par RBS, illustre un cas dans lequel une vitesse de dépôt supérieure à 0.1 nm/min, et en particulier de l'ordre de 7 nm/min a été mise en oeuvre, la température de dépôt ayant été choisie plus élevée que dans l'exemple de la figure 7A. Le dépôt de matériau métallique a été réalisé dans des conditions de température de dépôt de 70°C, le profil ayant été mesuré après un séjour de la couche de Si d'une durée de l'ordre de 30 minutes dans la solution de dépôt. Cette courbe C₆₀ montre un remplissage non uniforme et par le Ni et une absence (portion hachurée 700) de Ni à une profondeur supérieure à 0.8 µm dans la couche de Si d'épaisseur totale de 1µm.

Une variante d'exemple de procédé de métallisation suivant l'invention peut comprendre la séquence d'étapes suivantes :
Etape 1 : On plonge un substrat poreux à métalliser dans une solution froide d'éthanol c'est-à-dire à une température inférieure à la température ambiante qui peut être comprise dans l'intervalle ]0°C ; 25°C] et de préférence proche de 0°C;
Etape 2 : On rince le substrat poreux dans l'eau froide, par exemple dans de l'eau ayant une température comprise dans l'intervalle ]0°C ; 25°C] et de préférence proche de 0°C;
Etape 3 : On trempe le substrat poreux dans la solution de dépôt maintenue à basse température, i.e. dans l'intervalle : ]0°C ; 25°C] et de préférence autour de 0°C.
Etape 4 : On retire la solution de dépôt de la surface du substrat 10 par centrifugation ;
Etape 5 : la solution piégée à l'intérieur des pores constitue la source de dépôt du Ni. La solution ainsi piégée dans les pores peut être ensuite chauffée, en trempant le substrat dans de l'eau chaude par exemple supérieure à 25°C.

Selon cette possibilité de mise en oeuvre, on place le matériau à métalliser dans la solution de dépôt à une température basse proche de 0°C et dans des conditions permettant d'amorcer un dépôt selon une vitesse de dépôt du matériau métallique inférieure ou égale à 0.1 nm/min. Puis, on réalise la centrifugation afin de retirer la solution de dépôt de la surface du matériau poreux tout en conservant cette solution à l'intérieur de la porosité.

On trempe à nouveau le matériau poreux dans un bain à une température supérieure à 25°C afin cette fois d'avoir une vitesse de dépôt plus importante.

Dans ce cas, il n'y a pas de risque de colmater l'entrée des pores. En effet, la solution étant déjà située à l'intérieur des pores, le dépôt se fait, de façon uniforme, dans toute l'épaisseur du substrat.

Cette séquence d'étapes qui vient d'être donnée peut être éventuellement répétée une ou plusieurs fois.

En variante de l'étape 5, on place le substrat sur un support chauffant ou un plateau de maintien (« chuck » suivant la terminologie anglo-saxonne), tandis que l'eau est déversée sur le substrat.

Un procédé suivant l'invention s'applique tout particulièrement au Si poreux mais peut également s'appliquer au remplissage d'autres types de matériaux poreux dont la porosité est par exemple telle qu'illustrée sur les figures 8A-8C, avec une porosité de fissures 11 ou est constituée par des tranchées 11 ayant un facteur de forme (« aspect ratio » selon la terminologie anglo-saxonne) H/d important, avec H la hauteur des fissures (mesurée selon l'axe z du repère orthogonal [O,x,y,z] sur les figures 8A-8C), avec d la dimension critique ou largeur des fissures (mesurée dans le plan [O,x,y]).

Le facteur de forme H/d des fissures 11 peut être par exemple d'au moins 100, par exemple de l'ordre de 1000.

Le procédé de métallisation peut s'appliquer en particulier à la métallisation de structures obtenues par lithographie et gravure telles que celles mises en oeuvre dans les dispositifs microélectroniques ou les micro-systèmes.

Dans l'un ou l'autre des exemples de procédé décrits précédemment, on fait référence à une faible vitesse de dépôt du matériau métallique, et en particulier une vitesse de dépôt inférieure ou égale à 0.1 nm/min.

Une telle vitesse de dépôt peut être déterminée par exemple par le biais d'images obtenues par exemple par microscopie à balayage sur lesquelles on mesure des épaisseurs de matériau métallique déposé à différents instants que l'on rapporte à une durée écoulé entre ces instants.

Une autre méthode de mesure de vitesse de dépôt peut consister à être par exemple à peser la structure poreuse sur laquelle on effectue le dépôt à différents instants, et à rapporter la différence de masse obtenue à une durée écoulée entre ces instants.

## Revendications

1. Procédé de métallisation de matériau poreux comprenant le dépôt d'un matériau métallique en phase liquide sur le matériau poreux, à l'aide d'une solution comprenant des ions métallique, **caractérisé en ce que** les conditions de température de la solution, de pH de la solution, et de concentration en ions métallique de la solution, sont choisies de manière à permettre de réaliser le dépôt à une vitesse de dépôt non-nulle du matériau métallique et inférieure ou égale à 0.1 nm/min.

2. Procédé selon la revendication 1, dans lequel le matériau poreux est du Si.

3. Procédé selon la revendication 2, dans lequel le pH de la solution est inférieur à 7.

4. Procédé selon l'une des revendications 1 à 3, dans lequel la concentration molaire en ions métalliques de la solution est inférieure à 0.1 M.

5. Procédé selon l'une des revendications 1 à 4, dans lequel la température de dépôt est choisie dans l'intervalle : ]0°C; 25°C].

6. Procédé selon l'une des revendications 1 à 5, dans lequel la solution métallique comprend un agent surfactant.

7. Procédé selon l'une des revendications 1 à 5, dans lequel préalablement au dépôt de matériau métallique, on place le substrat dans une solution contenant un agent surfactant.

8. Procédé selon l'une des revendications 1 à 7, dans lequel les ions métalliques sont des ions Ni⁺, ou Ag⁺, ou Au³⁺, ou Cu²⁺.

9. Procédé selon l'une des revendications 1 à 8, dans lequel le matériau poreux est nano-poreux avec de pores de diamètre compris entre 5 nm et 20 nm.

10. Procédé de fabrication d'un dispositif microélectronique comprenant un procédé de métallisation selon l'une quelconque des revendications précédentes.
